# EUROPÄISCHE PATENTSCHRIFT

(11) **EP 3 042 418 B1**
(45) Veröffentlichungstag und Bekanntmachung des Hinweises auf die Patenterteilung: **03.07.2019**
(21) Anmeldenummer: 14741335.5
(22) Anmeldetag: 21.07.2014
(51) Int. Cl.: H01R 12/71, H05K 5/00, H01R 4/28, H01R 4/60, H01R 13/24, G01D 11/24

(54) **ANPRESSELEMENT, ELEKTRISCHES/ELEKTRONISCHES BAUTEIL**
PRESSING ELEMENT, ELECTRICAL/ELECTRONIC COMPONENT
ÉLÉMENT DE PRESSION, COMPOSANT ÉLECTRIQUE/ÉLECTRONIQUE

(30) Priorität: 05.09.2013 DE 102013217706
(43) Veröffentlichungstag der Anmeldung: 13.07.2016
(73) Patentinhaber: Robert Bosch GmbH, 70442 Stuttgart (DE)
(72) Erfinder: HERRMANN, Alexander, 72764 Reutlingen (DE); HAEUSSERMANN, Conrad, 72818 Trochtelfingen (DE); WOERNLE, Wolfgang, 72149 Neustetten (DE); BERTSCH, Benjamin, 72805 Lichtenstein (DE)
(86) Internationale Anmeldenummer: PCT/EP2014/065626
(87) Internationale Veröffentlichungsnummer: WO 2015/032538

(56) Entgegenhaltungen:
- EP-A1- 2 418 666
- WO-A1-2007/051491
- WO-A1-2013/031204
- CN-A- 102 507 336
- DE-A1-102011 079 446
- DE-B3-102012 003 979
- US-A- 5 417 591

## Beschreibung

Die Erfindung betrifft ein elektrisches/elektronisches Sensorbauteil mit einem mehrteiligen Gehäuse und mit wenigstens einem elektrischen Sensorelement das wenigstens einen elektrisch leitfähigen Berührungskontakt aufweist, und mit einem Anpresselement, das der dem Berührungskontakt abgewandten Seite des Sensorelements zugeordnet und vorgespannt gegen das Sensorelement in dem Gehäuse gehalten ist.

### Stand der Technik

Bauteile der eingangs genannten Art sind aus dem Stand der Technik bekannt.

Zur Kontaktierung elektrischer Bauelemente ist es bekannt, neben formschlüssigen Steckverbindungen auch elektrische Verbindungen vorzusehen, die nur durch einen Berührungskontakt realisiert werden. Dazu wird das elektrische Bauelement mit einem Berührungskontakt gegen einen Berührungsgegenkontakt gedrängt beziehungsweise gepresst, um den elektrischen Kontakt dauerhaft zu gewährleisten. Die hierfür notwendige Anpress- beziehungsweise Andruckkraft wird dabei häufig durch ein in das Gehäuse eingesetztes elastisch verformbares Anpresselement erzeugt, das beispielsweise zwischen Bauelement und Gehäuse vorgespannt gehalten ist. Häufig dient dabei das Anpresselement gleichzeitig auch als Dichtelement, beispielsweise bei einem Drucksensor, um den Sensor einerseits dem zu erfassenden Druck auszusetzen und andererseits empfindliche Bereiche des Sensors vor dem den Druck bereitstellenden Medium zu schützen. Das Anpresselement ist daher ringförmig ausgebildet. Aus Kostengründen ist das Bauelement häufig möglichst klein auszulegen, wobei sich gleichzeitig die Abmessungen des Anpresselementes aus technologischen Gründen nicht beliebig verkleinern lassen. In Zusammenhang mit den außerdem noch zu berücksichtigenden Fertigungstoleranzen führt dies dazu, dass eine vollflächige Auflage des Bauelements auf dem Anpresselement nicht immer gewährleistet werden kann. Bei einer ringförmigen Anpressfläche kann es dabei dazu kommen, dass das Bauelement aufgrund der Verformung des Anpresselements von dem Anpresselement abrutscht.

Die Offenlegungsschrift DE 10 2011 079 446 A1 offenbart außerdem ein Sensorbauteil mit einem Sensorelement, wobei das Sensorbauteil derart ausgebildet ist, dass die Anordnung des Sensorelementes in einem Gehäuse des Sensorbauteils über eine 3-Punkt-Anlage erfolgt. Aus der Patentschrift US 5,417,591 A geht eine Anschlussvorrichtung mit einem aus Kunststoffmaterial gebildeten Trägerelement hervor. Das Trägerelement weist ein Schirmblech auf, das von Kontaktelementen einer elektrischen Anordnung durchsetzbar ist, wobei dann jedem der Kontaktelemente jeweils ein elektrisch leitend mit dem Schirmblech verbundener Durchführungskondensator zugeordnet ist.

### Offenbarung der Erfindung

Das erfindungsgemäße Sensorbauteil mit den Merkmalen des Anspruchs 1 hat den Vorteil, dass ein derartiges Abrutschen des Sensorelements auf einfache Art und Weise verhindert wird. Dies wird durch eine besondere Formgebung des Anpresselementes erreicht, welche ein entsprechendes Verformen des Anpresselementes verhindert. Erfindungsgemäß ist hierbei vorgesehen, dass das Anpresselement eine ringförmige Anpressfläche für das Sensorelement aufweist, wobei eine Außenkontur der Anpressfläche größer ist als eine Außenkontur des anzupressenden Sensorelements, und dass die Anpressfläche eine ringförmige Erhebung aufweist, die eine Auflagefläche für das Sensorelement bildet. Das Anpresselement weist somit eine ringförmige Erhebung auf, die sich von der übrigen Anpressfläche abhebt. Dadurch werden an dem Anpresselement Bereiche mit unterschiedlicher Materialstärke realisiert, welche eine Verformung des Anpresselementes bereichsweise erschweren, sodass die Verformung bei einem nur zum Teil auf der Anpressfläche aufliegenden Sensorelement besser in das Anpresselement eingeleitet wird, sodass die Verformung nicht zu einem Abrutschen des Sensorelements führen kann.

Gemäß einer vorteilhaften Weiterbildung der Erfindung ist vorgesehen, dass das Anpresselement ringförmig ausgebildet ist. In diesem Fall ist also das Anpresselement insgesamt ringförmig ausgebildet, sodass es einen Durchbruch beziehungsweise eine lichte Weite aufweist, und weist an einer Seite die Anpressfläche sowie die Auflagefläche auf, mit welcher es das Sensorelement beaufschlagt beziehungsweise beaufschlagen kann. Die Auflagefläche erstreckt sich zweckmäßigerweise koaxial zur Ringform des Anpresselementes. Dabei kann die Ringform kreisringförmig, ovalringförmig oder auch mehreckringförmig, insbesondere in Form eines Rechtecks, ausgebildet sein. Von Bedeutung ist, dass das Anpresselement einen geschlossenen Ring bildet. Durch die vollständig ringförmige Ausbildung lässt sich das Anpresselement beispielsweise direkt über einem Sensorteil des Sensorelements mit dem Durchbruch platzieren und zwischen einem Gehäuseflansch und dem Sensorelement einspannen, sodass durch den Gehäuseflansch das Sensorteil mit beispielsweise der Umgebung eines Gehäuses in Verbindung steht, während das übrige Sensorelement geschützt ist.

Gemäß einer bevorzugten Weiterbildung der Erfindung ist vorgesehen, dass sich die Anpressfläche radial von einer Mantelinnenwand zu einer Mantelaußenwand des ringförmigen Anpresselementes erstreckt. Unter radial ist in diesem Zusammenhang im Wesentlichen zunächst einmal nur ein Erstrecken von innen nach außen ausgehend von einem Mittelpunkt des Anpresselements zu verstehen. Exakt radial erstreckt sich die Anpressfläche selbstverständlich nur bei einem kreisringförmigen Anpresselement.

Weiterhin ist bevorzugt vorgesehen, dass sich die Mantelinnenwand die Erhebung mitbildend axial bis zur Anpressfläche erstreckt. Die Erhebung grenzt somit innen an die Mantelinnenwand an, wobei sie sich nach außen hin nur bereichsweise über die Anpressfläche erstreckt, sodass ein Umfangsbereich der ursprünglichen Anpressfläche erhalten bleibt. Hierdurch wird erreicht, dass wenn das Anpresselement gegen das Sensorelement gepresst wird, das Sensorelement nicht oder nicht so weit in das Anpresselement beziehungsweise in Material des Anpresselementes hineintaucht, sodass infolge der Verformung gegebenenfalls überstehendes Material des Anpresselementes das Sensorelement seitlich mit einer geringeren Kraft beaufschlagt.

Gemäß einer bevorzugten Weiterbildung der Erfindung ist vorgesehen, dass die Mantelinnenwand bezüglich der Auflagefläche und/oder der Anpressfläche schräg ausgerichtet ist. Durch eine schräge Ausbildung der Mantelinnenwand erfolgt eine Krafteinleitung in das Anpresselement, die ein Einknicken der Mantelinnenwand vermeidet.

Insbesondere ist bevorzugt vorgesehen, dass die Mantelinnenwand derart schräg ausgerichtet ist, dass die lichte Weite des ringförmigen Anpresselementes von der Auflagefläche ausgehend abnimmt. Hierdurch wird ein besonders stabiles Anpresselement geschaffen, dass das Sensorelement sicher trägt beziehungsweise stützt.

Ferner ist bevorzugt vorgesehen, dass das Anpresselement aus Silikon oder aus einem thermoplastischen Elastomer gefertigt ist. Hierdurch erhält es eine vorteilhafte Flexibilität und gewährleistet eine hohe Lebensdauer.

Erfindungsgemäß weist das Gehäuse zumindest zwei Gehäuseteile auf, wobei das Anpresselement und das Sensorelement zwischen den beiden Gehäuseteilen durch das Anpresselement vorgespannt gehalten sind. Das Anpresselement und das Sensorelement werden somit zwischen den beiden Gehäuseteilen verspannt gehalten, sodass zusätzliche Haltemittel nicht benötigt werden. Besonders bevorzugt ist das Anpresselement im Bereich eines Anschlussstutzens eines der Gehäuseteile angeordnet und insgesamt ringförmig ausgebildet.

Erfindungsgemäß weist ein anderes der Gehäuseteile wenigstens einen Berührungsgegenkontakt auf, gegen welchen das elektrische Sensorelement durch das Anpresselement gedrängt wird. Das Sensorelement wird somit mittels des Anpresselements in elektrischen Berührungskontakt mit dem Berührungsgegenkontaktelement dauerhaft verbunden, wenn die Gehäuseteile zusammengesetzt werden.

Im Folgenden soll die Erfindung anhand eines Ausführungsbeispiels näher erläutert werden. Dazu zeigen
- Figur 1: ein Bauteil mit einem elektrischen Bauelement in einer Schnittdarstellung,
- Figur 2: eine perspektivische Draufsicht auf ein Gehäuseteil des Bauteils,
- Figur 3: eine vergrößerte Schnittdarstellung durch das Bauteil,
- Figur 4: eine perspektivische Draufsicht auf ein vorteilhaftes Anpresselement des Bauteils, und
- Figur 5: eine schematische Schnittdarstellung durch das Bauteil mit dem vorteilhaften Anpresselement.

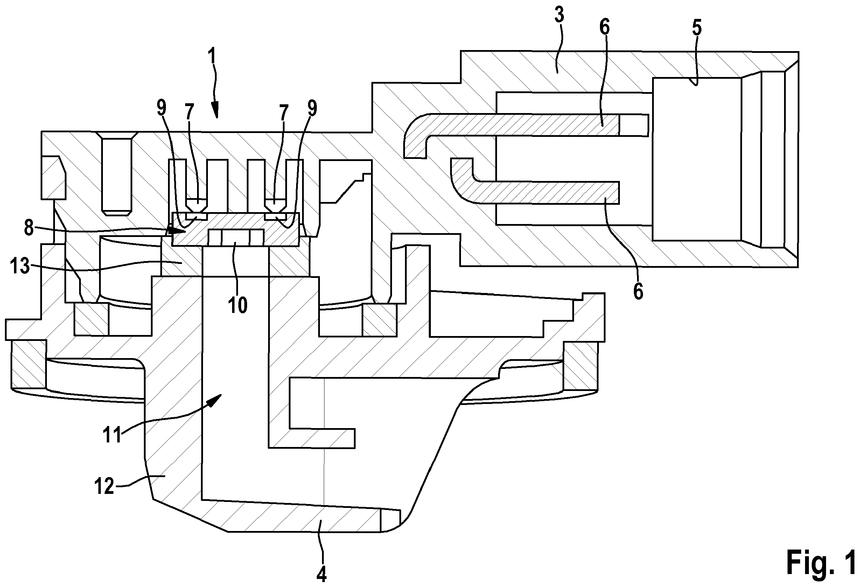

Figur 1 zeigt in einer Schnittdarstellung ein elektrisches Bauteil 1, das als Sensorbauteil ausgebildet ist. Das Bauteil 1 weist ein mehrteiliges Gehäuse auf, das von zwei Gehäuseteilen 3, 4 gebildet wird, die einen Raum dicht einschließend aneinander angeordnet sind.

Das erste Gehäuseteil 3 ist als Anschlussteil ausgebildet und weist hierzu eine Steckeraufnahme 5 auf, in welche elektrische Kontaktstifte 6 hineinragen. Die Kontaktstifte 6 sind elektrisch mit Berührungsgegenkontakten 7 verbunden, die dem Raum zugewandt sind. An den Berührungsgegenkontakten 7 liegt ein elektrisches Bauelement 8, das vorliegend als Sensorelement ausgebildet ist, mit jeweils entsprechenden Berührungskontakten 9 an, um eine elektrische Verbindung zu den Kontaktstiften 6 herzustellen.

Das Bauelement 8 weist auf seiner den Berührungskontakten 8 gegenüberliegenden Seite einen Sensor 10 auf, der als Drucksensor ausgebildet ist.

Das Gehäuseteil 4 weist einen Kanal 11 auf, der durch einen Anschlussstutzen 12 von dem eingeschlossenen Raum in die Umgebung führt. Die beiden Gehäuseteile 3 und 4 sind dabei derart aneinander angeordnet, dass der Kanal 11 dem Sensor 10 gegenüberliegend endet.

Zwischen dem Gehäuseteil 4 und dem Bauelement 8 ist weiterhin ein elastisch verformbares Anpresselement 13 vorgesehen, das aus einem Kunststoffmaterial, insbesondere aus Silikon oder aus einem thermoplastischen Elastomer, gefertigt ist.

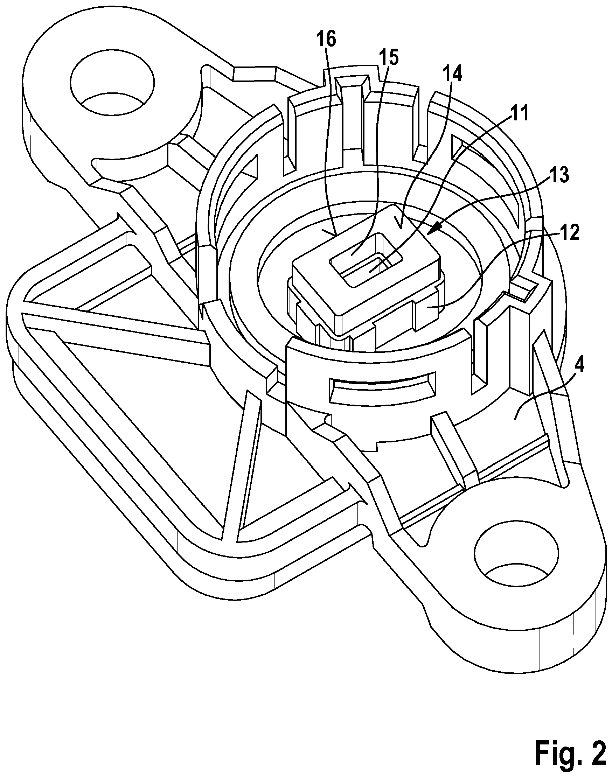

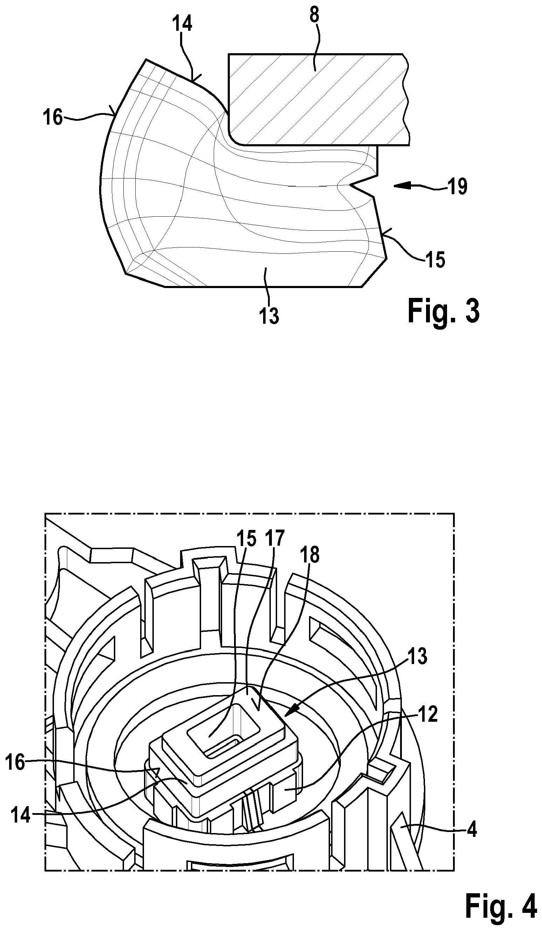

Figur 2 zeigt eine perspektivische Draufsicht auf das Gehäuseteil 4 und das daran angeordnete Anpresselement 13. Das Anpresselement 13 liegt auf dem freien Ende des Anschlussstutzens 12 auf und ist ringförmig ausgebildet, sodass es den Kanal 11 weiterführt. Vorliegend weisen der Kanal 11 und das Ringelement 13 dabei eine rechteckförmige Kontur auf. Die dem Bauelement 13 zugewandte Anpressfläche 14 des Anpresselements 3 ist vorliegend eben ausgebildet. Die Anpressfläche 14 erstreckt sich dabei von einer Mantelinnenwand 15 bis zu einer Mantelaußenwand 16, die parallel zueinander und senkrecht zur Anpressfläche 14 ausgerichtet sind. Diese Ausführungsform des Anpresselements 13 entspricht einer bekannten Ausführungsform. Da sich die inneren Abmessungen des Anpresselements 13 aus technologischen Gründen nicht beliebig verkleinern lassen, und in Zusammenhang mit Fertigungstoleranzen, wird vorausgesetzt, dass die Mantelaußenwand eine Kontur aufweist, die die Außenkontur des Bauelements 8 überragt, sodass das Bauelement 8 nur bereichsweise auf der Anpressfläche 14 des Anpresselements 13 aufliegt, wie in Figur 3 gezeigt.

Im zusammengesetzten Zustand wird das Bauelement 8, wie in Figur 3 in einer schematischen Schnittdarstellung gezeigt, in das Material des ringförmigen Anpresselementes 13 hineingepresst, wodurch sich die in Figur 3 dargestellte Verformung ergibt. Das Anpresselement 13 wirkt insofern als Dichtelement, das den Kanal 11 zu dem Sensor 10 weiterführt, ohne dass die weiteren Elemente des Bauteils 1 mit dem durch den Kanal 11 geführten Medium in Berührung kommen. Dadurch können die elektrischen/elektronischen Komponenten des Bauteils 1 sicher vor äußeren Einflüssen, insbesondere vor Verschmutzung geschützt werden.

Dringt das Bauelement 8, wie dargestellt, in das Material des Anpressteils 13 ein, so entsteht zusätzlich zu der Anpresskraft eine Seitenkraft F, die das Bauelement 8 seitlich beaufschlagt und dazu führen kann, dass dieses von dem Anpresselement 13 abrutscht.

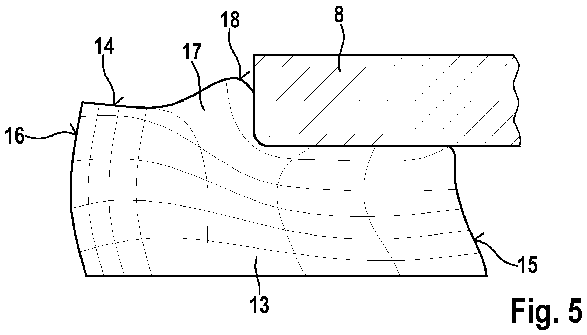

Um dies zu verhindern, wird eine Ausführungsform des Anpresselements 13 vorgeschlagen, wie sie in Figur 4 und Figur 5 gezeigt ist. Dabei ist vorgesehen, dass die Anpressfläche 14 eine ringförmige Erhebung 17 aufweist, die eine Auflagefläche 18 für das Bauelement 8 bildet. Die ringförmige Erhebung 17 grenzt an die Mantelinnenwand 15 an und erstreckt sich nur bereichsweise über die Anpressfläche 14, sodass ein Umfangsbereich der ursprünglichen Anpressfläche 14 erhalten bleibt. Es entsteht somit eine Stufe an der Anpressfläche 14 des Anpresselements 13. Vorzugsweise erstreckt sich die Außenkontur der Erhebung 17 maximal nur geringfügig über die Außenkontur des Bauelements 8 hinaus, sodass keine oder nur sehr geringe Seitenkräfte auf das Bauelement 8 im zusammengesetzten Zustand des Bauteils 1 entstehen. Wird nunmehr, bei gleichbleibenden Abmessungen des Bauelements 8, das Bauteil 1 wie zuvor beschrieben zusammengefügt, sodass das Anpresselement 13 gegen das Bauelement 8 gedrängt wird, so erfolgt eine Verformung des Anpresselements 13, wie es in einer schematischen Darstellung in Figur 5 gezeigt ist.

Durch die ringförmige Erhebung 17 ergibt sich eine Verformung des Anpresselements 13, bei welcher die seitlich wirkende Kraft, die durch das Eintauchen des Bauelements 8 in das Material des Anpresselements 13 entsteht, im Vergleich zu dem vorher beschriebenen Beispiel sehr viel geringer ausfällt.

Zusätzlich ist gemäß dem Ausführungsbeispiel von Figur 5 außerdem vorgesehen, dass die Mantelinnenwand 15 schräg ausgebildet ist. Die Mantelinnenwand 15 verläuft dabei schräg bezüglich der Mantelaußenwand 16 und der Anpressfläche 14. Hierdurch wird verhindert, dass das Anpresselement 13 bei einer hohen Belastung an der Mantelinnenwand 15 einknickt, wie es in Figur 3 an der mit einem Pfeil 19 markierten Stelle der Fall ist.

Durch die stufenförmige Ausbildung der Anpressfläche 14 wird erreicht, dass beim Verpressen des Anpresselements 13 das seitliche Herausquellen von Kunststoffmaterial und damit die resultierenden seitlichen Schubkräfte, die auf das Bauelement 8 wirken, reduziert werden. Des Weiteren ist durch die schräge Ausrichtung der Mantelinnenwand 15 des Anpresselements 13 ein Einknicken der Mantelinnenwand 15 verhindert.

## Patentansprüche

1. Elektrisches/elektronisches Sensorbauteil (1), mit einem mehrteiligen Gehäuse und mit wenigstens einem elektrischen Sensorelement (8), das wenigstens einen elektrisch leitfähigen Berührungskontakt (9) aufweist, und mit einem elastisch verformbaren Anpresselement (13), wobei das Anpresselement (13) eine ringförmige Anpressfläche (14) für das Sensorelement (8) aufweist, und wobei eine Außenkontur der Anpressfläche (14) größer ist als eine Außenkontur des anzupressenden Sensorelements (8), wobei das Anpresselement (13) der dem Berührungskontakt (9) abgewandten Seite des Sensorelements (8) zugeordnet und vorgespannt gegen das Sensorelement (8) in dem Gehäuse gehalten ist, wobei die Anpressfläche (14) eine ringförmige Erhebung (17) aufweist, die eine Auflagefläche (18) für das Sensorelement (8) bildet, wobei das Gehäuse wenigstens zwei Gehäuseteile (3,4) aufweist, wobei das Sensorelement (8) zwischen den beiden Gehäuseteilen (3,4) unter Zwischenschaltung des Anpresselements (13) vorgespannt gehalten ist, wobei einer der Gehäuseteile (4) einen Berührungsgegenkontakt (7) aufweist, gegen welchen das elektrische Sensorelement (8) mit seinem Berührungskontakt (7) mittels des Anpresselements (13) gedrängt ist.

2. Sensorbauteil (1) nach Anspruch 1, **dadurch gekennzeichnet, dass** das Anpresselement (13) ringförmig ausgebildet ist.

3. Sensorbauteil (1) nach Anspruch 1 oder 2, **dadurch gekennzeichnet, dass** sich die Anpressfläche (18) von einer Mantelinnenwand (15) zu einer Mantelaußenwand (16) des ringförmigen Anpresselementes (13) erstreckt.

4. Sensorbauteil (1) nach einem der vorhergehenden Ansprüche, **dadurch gekennzeichnet, dass** sich die Mantelinnenwand (15) die Erhebung (17) mitbildend axial bis zur Auflagefläche (18) erstreckt.

5. Sensorbauteil (1) nach einem der vorhergehenden Ansprüche, **dadurch gekennzeichnet, dass** die Mantelinnenwand (15) bezüglich der Auflagefläche (18) und/oder der Anpressfläche (17) schräg ausgerichtet ist.

6. Sensorbauteil (1) nach einem der vorhergehenden Ansprüche, **dadurch gekennzeichnet, dass** die Mantelinnenwand (15) derart schräg ausgerichtet ist, dass die lichte Weite des ringförmigen Anpresselements (13) von der Auflagefläche (18) ausgehend abnimmt.

7. Sensorbauteil (1) nach einem der vorhergehenden Ansprüche, **dadurch gekennzeichnet, dass** das Anpresselement (13) aus Silikon oder aus einem thermoplastischen Elastomer gefertigt ist.

## Claims

1. Electrical/electronic sensor component (1) having a multipartite housing and having at least one electrical sensor element (8) which has at least one electrically conductive touch contact (9), and having an elastically deformable pressing element (13), wherein the pressing element (13) has an annular pressing surface (14) for the sensor element (8), and wherein an outer contour of the pressing surface (14) is larger than an outer contour of the sensor element (8) which is to be pressed, wherein the pressing element (13) is associated with that side of the sensor element (8) which is averted from the touch contact (9) and is held in the housing such that it is prestressed against the sensor element (8), wherein the pressing surface (14) has an annular raised portion (17) which forms a bearing surface (18) for the sensor element (8), wherein the housing has at least two housing parts (3, 4), wherein the sensor element (8) is held in a prestressed manner between the two housing parts (3, 4) with the interposition of the pressing element (13), wherein one of the housing parts (4) has a mating touch contact (7) against which the electrical sensor element (8) is pushed by way of its touch contact (7) by means of the pressing element (13).

2. Sensor component (1) according to Claim 1, **characterized in that** the pressing element (13) is of annular design.

3. Sensor component (1) according to Claim 1 or 2, **characterized in that** the pressing surface (18) extends from a casing inner wall (15) to a casing outer wall (16) of the annular pressing element (13).

4. Sensor componenet (1) according to one of the preceding claims, **characterized in that** the casing inner wall (15) extends axially as far as the bearing surface (18), so as to form the raised portion (17) at the same time.

5. Sensor componenet (1) according to one of the preceding claims, **characterized in that** the casing inner wall (15) is oriented obliquely with respect to the bearing surface (18) and/or the pressing surface (17) .

6. Sensor componenet (1) according to one of the preceding claims, **characterized in that** the casing inner wall (15) is oriented obliquely in such a way that the clear width of the annular pressing element (13) decreases starting from the bearing surface (18).

7. Sensor componenet (1) according to one of the preceding claims, **characterized in that** the pressing element (13) is manufactured from silicone or from a thermoplastic elastomer.

## Revendications

1. Composant de détection (1) électrique/électronique, comprenant un boîtier en plusieurs parties et comprenant au moins un élément de détection (8) électrique qui possède au moins un contact de toucher (9) électriquement conducteur, et comprenant un élément de pressage (13) déformable élastiquement, l'élément de pressage (13) possédant une surface de pressage (14) annulaire pour l'élément de détection (8) et un contour extérieur de la surface de pressage (14) étant plus grand qu'un contour extérieur de l'élément de détection (8) à presser, l'élément de pressage (13) étant associé au côté de l'élément de détection (8) à l'opposé du contact de toucher (9) et étant maintenu avec précontrainte contre l'élément de détection (8) dans le boîtier, la surface de pressage (14) possédant un bossage (17) annulaire qui forme une surface d'appui (18) pour l'élément de détection (8), le boîtier possédant au moins deux parties de boîtier (3, 4), l'élément de détection (8) étant maintenu précontraint entre les deux parties de boîtier (3, 4) en interposant l'élément de pressage (13), l'une des parties de boîtier (4) possédant un contact homologue de toucher (7) contre lequel l'élément de détection (8) électrique est poussé par son contact de toucher (7) au moyen de l'élément de pressage (13).

2. Composant de détection (1) selon la revendication 1, **caractérisé en ce que** l'élément de pressage (13) est réalisé de forme annulaire.

3. Composant de détection (1) selon la revendication 1 ou 2, **caractérisé en ce que** la surface de pressage (18) s'étend d'une paroi interne d'enveloppe (15) à une paroi externe d'enveloppe (16) de l'élément de pressage (13) annulaire.

4. Composant de détection (1) selon l'une des revendications précédentes, **caractérisé en ce que** la paroi interne d'enveloppe (15) s'étend dans le sens axial jusqu'à la surface d'appui (18) en formant conjointement le bossage (17).

5. Composant de détection (1) selon l'une des revendications précédentes, **caractérisé en ce que** la paroi interne d'enveloppe (15) est orientée en biais par rapport à la surface d'appui (18) et/ou à la surface de pressage (17).

6. Composant de détection (1) selon l'une des revendications précédentes, **caractérisé en ce que** la paroi interne d'enveloppe (15) est orientée en biais de telle sorte que la largeur utile de l'élément de pressage (13) annulaire diminue à partir de la surface d'appui (18).

7. Composant de détection (1) selon l'une des revendications précédentes, **caractérisé en ce que** l'élément de pressage (13) est fabriqué en silicone ou en un élastomère thermoplastique.
